**Europäisches Patentamt**

**European Patent Office**

**Office européen des brevets**

(19)

(11) Veröffentlichungsnummer: **0 073 353**
**A1**

## (12) EUROPÄISCHE PATENTANMELDUNG

(21) Anmeldenummer: **82106927.5**

(22) Anmeldetag: **30.07.82**

(51) Int. Cl.³: **H 03 F 3/30**

(30) Priorität: **24.08.81 DE 3133396**

(43) Veröffentlichungstag der Anmeldung: **09.03.83**
**Patentblatt 83/10**

(84) Benannte Vertragsstaaten: **DE FR GB IT NL**

(71) Anmelder: **SIEMENS AKTIENGESELLSCHAFT, Berlin
und München Wittelsbacherplatz 2,
D-8000 München 2 (DE)**

(72) Erfinder: **Dietze, Andreas, Dipl.-Ing.,
Teufelsgrabenweg 4, D-8151 Grub (DE)**
Erfinder: **Kriedt, Hans, Ing. grad., Triester Strasse 33,
D-8000 München 80 (DE)**

(54) **Halbleiter-Verstärkerschaltung.**

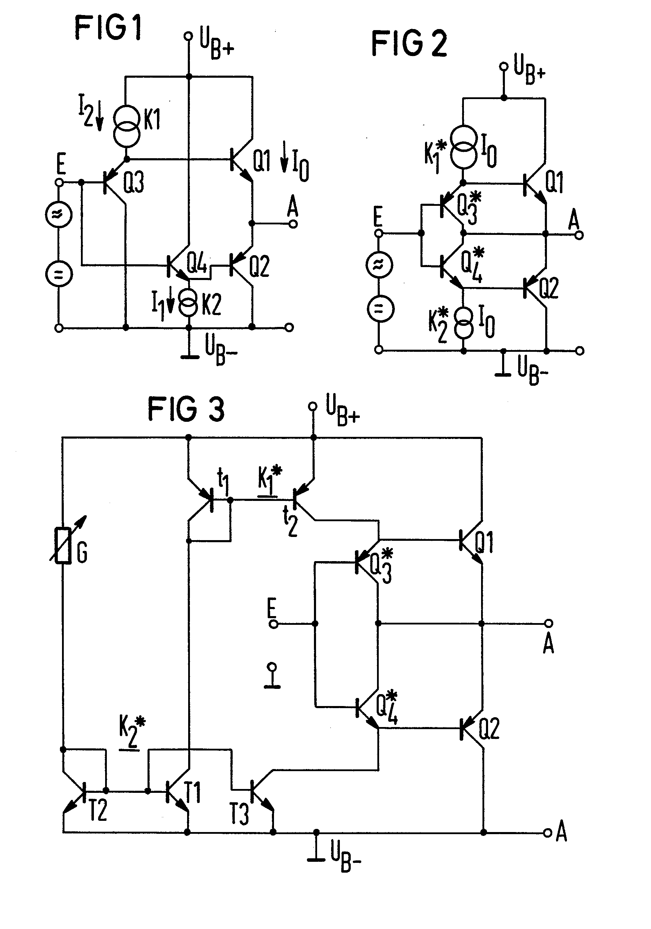

(57) Die Erfindung geht von einer integrierbaren Transistor-verstärkerschaltung aus, wie sie dem Stande der Technik entspricht und in Fig. 1 dieser Anmeldung dargestellt ist. Gemäß der vorliegenden Erfindung ist nun angestrebt, eine solche Schaltung derart auszugestalten, daß sie eine niederohmige Ausgangsstufe bildet, die bis zu Spannungen von ca. $U_B-2U_{BE}$ aussteuerbar ist und die im Verhältnis zu den bekannten Verstärkerschaltungen dieser Art nur einen kleinen Ruhestrom benötigt. Hierzu liegt bei dem erfindungsgemäßen Niederfrequenzverstärker der Signaleingang am Basisanschluß zweier zueinander komplementärer Transistoren, deren Emitteranschlüsse durch je eine Konstantstromquelle versorgt sind. Die Kollektorelektroden dieser beiden Transistoren sind gemeinsam mit dem Signalausgang des Verstärkers verbunden. Am Verstärkerausgang liegen außerdem die Emitter zweier weiterer zueinander komplementärer Transistoren, deren Kollektoren mit der zugehörigen Versorgungsklemme verbunden sind und deren Basisanschlüsse derart an die Emitteranschlüsse der beiden erstgenannten Transistoren geschaltet sind, daß die beiden jeweils auf die letztgenannte Art miteinander verbundenen Transistoren ebenfalls zueinander komplementär sind.

Siemens Aktiengesellschaft
Berlin und München

-/-

Unser Zeichen
VPA 81 P 1 1 1 7 E

## Halbleiter-Verstärkerschaltung

Die Erfindung bezieht sich auf eine Halbleiter-Verstärkerschaltung mit zwei zueinander komplementären Transistoren, deren Stromeingangselektroden mit dem Signalausgang der Verstärkerschaltung verbunden und deren Stromausgangselektroden an je eine durch eine Versorgungs-Gleichspannungsquelle beaufschlagte Versorgungsklemme gelegt sind, während ihre Steuerelektroden mit der Stromeingangselektrode jeweils eines weiteren zu dem betreffenden Transistor komplementären Transistors verbunden sind.

Ein Beispiel für eine bekannte Halbleiter-Verstärkerschaltung dieser Art ist in Figur 1 dargestellt. Das Ziel, das mit dieser Halbleiter-Verstärkerschaltung erreicht werden soll, ist eine monolithisch integrierbare, niederohmige NF-Ausgangsschaltung mit möglichst kleiner Stromaufnahme und einem Betriebsspannungsbereich ab etwa $(2\ U_{BE} + U_{\sim SS})$.

Um dieses Ziel zu erreichen, ist bei der bekannten Schaltung vorgesehen, daß der Kollektor eines ersten npn-Transistors Q1 mit dem positiven Pol der Versorgungsgleichspannungsquelle $U_B$ und der Kollektor eines ersten npn-Transistors Q2 mit dem negativen Pol der Gleichspannungsquelle $U_B$ verbunden ist, während die Emitter dieser beiden zueinander komplementären Transistoren Q1 und Q2 gemeinsam an die Ausgangsklemme A gelegt sind, welche ein gegen das Potential $U_{B-}$ oder $U_{B+}$ bezogenes Ausgangssignal des Verstärkers abgibt.

Die als Steuerelektrode dienenden Basisanschlüsse der beiden komplementären Transistoren Q1 und Q2 liegen am Emitter je eines weiteren Transistors Q3 bzw. Q4, sowie am Ausgang je einer in bekannter Weise ausgestalteten Konstantstromquelle K1 bzw. K2. Der den npn-Transistor Q1 steuernde Transistor Q3 ist vom pnp-Typ, der den pnp-Transistor Q2 steuernde Transistor Q4 hingegen vom npn-Typ. Die Konstantstromquelle K2, welche den Emitter des npn-Transistors Q4 mit dem Bezugspotential $U_{B-}$ verbindet, dient zur Stromversorgung dieses Transistors Q4. Sie liefert einen Konstantstrom $J_1$. Der den npn-Transistor Q1 steuernde Transistor Q3 ist hingegen von einer auf das positive Versorgungspotential $U_{B+}$ bezogenen Konstantstromquelle K1 versorgt, die den Strom $J_2$ liefert. Der Kollektor des Transistors Q3 ist am Potential $U_{B-}$, der des Transistors Q4 am Potential $U_{B+}$ angeschaltet.

Eine das Eingangssignal führende Eingangsklemme E ist, wiederum bezogen auf das Bezugspotential $U_{B-}$ (oder auf das Potential $U_{B+}$), derart beaufschlagt, daß das Eingangssignal sowohl eine Gleichspannungskomponente als auch eine Wechselspannungskomponente enthält, wie dies auch in der Zeichnung angedeutet ist.

Zweckmäßig stellt man die, z.B. durch je einen Stromspiegelverstärker in bekannter Ausführung gegebenen Konstantstromquellen K1 und K2 derart ein, daß sie einen Strom $J_1 = J_2$ liefern. Die Beziehung $J_1 = J_2 = J_0$ gilt, wenn die Transistorgeometrien von Q1 und Q2 denen der Transistoren Q4 und Q3 entsprechen und alle Transistoren untereinander thermische Kopplungen, wie sie in einer integrierten Schaltung gegeben sind, aufweisen.

Angestrebt ist nun gemäß der Erfindung, die Schaltung derart auszugestalten, daß eine niederohmige Ausgangsstufe erreicht ist, die bis zu Spannungen von ca. $U_B - 2 U_{BE}$ aussteuerbar ist und nur einen kleinen Ruhestrom von $2J_0$ benötigt. Es ist nämlich aufgrund der mit den bekannten Verstärkerschaltungen der in Figur 1 dargestellten Art gemachten Erfahrungen festzustellen, daß sie einen merklich größeren Ruhestrom, nämlich gleich $3J_o$, haben.

Um dieses Ziel zu erreichen wird gemäß der Erfindung die eingangs definierte Halbleiter-Verstärkerschaltung derart ausgebildet, daß die Stromeingangselektroden der beiden weiteren komplementären Transistoren über je eine Konstantstromquelle mit der zugehörigen Versorgungsklemme verbunden sind, während ihre Steuerelektroden gemeinsam an die durch ein Eingangssignal zu beaufschlagende Eingangsklemme gelegt und ihre Stromausgangselektroden miteinander sowie mit dem Ausgang des Verstärkers verbunden sind.

Die entsprechende Schaltung ist in Figur 2 bzw. in Figur 3 dargestellt. Die verwendeten Transistoren sind Bipolartransistoren. Anstelle der Bipolartransistoren können aber auch MOS-Feldeffekttransistoren treten, insbesondere solche vom selbstsperrenden Typ, so daß dann mit anderen Worten, die Verstärkerschaltung gemäß der Erfindung in CMOS-Technik realisiert ist.

Wie aus Figur 2 ersichtlich, liegt die Signaleingangsklemme E an den Basisanschlüssen zweier komplementärer Transistoren $Q_3^*$ und $Q_4^*$, deren Stromausgangselektroden, also Kollektorelektroden, miteinander verbunden und an den Signalausgang A der Verstärkerschaltung gelegt sind. Die Stromeingangselektroden, also die Emitterelektroden, der beiden komplementären Transistoren $Q_3^*$ und $Q_4^*$ sind über je eine dem Leitungstyp des betreffenden Komplementärtransistors angepaßte Konstantstromquelle $K_1^*$ bzw. $K_2^*$ an die jeweils zugehörige Klemme für die Versorgungsspannung $U_B$ gelegt. Im Falle des pnp-Transistors $Q_3^*$ ist dies die durch wenigstens einen pnp-Transistor gegebene Konstantstromquelle $K_1^*$, über die der Emitter des Transistors $Q_3^*$ an den positiven Pol $U_{B+}$ der Versorgungsspannung gelegt ist. Der npn-Transistor $Q_4^*$ hingegen liegt über die durch wenigstens einen npn-Transistor gegebene Konstantstromquelle $K_2^*$ am Bezugspotential, d.h. also an der negativen Klemmen $U_{B-}$ der Versorgungsspannungsquelle.

Gemäß der Erfindung ist außerdem der Emitter des pnp-
Transistors $Q_3^*$ unmittelbar mit der Steuerelektrode, also
der Basiselektrode, eines npn-Transistors Q1 verbunden,
dessen Kollektor unmittelbar mit der das positive Versorgungspotential liefernden Klemme $U_{B+}$ der Versorgungsspannungsquelle und dessen Emitter mit dem Signalausgang A
der Verstärkerschaltung verbunden ist. Der Emitter des
npn-Transistors $Q_4^*$ liegt andererseits gemäß der Erfindung
an der Basis eines pnp-Transistors Q2, dessen Emitter
ebenfalls unmittelbar mit dem Verstärkerausgang A verbunden ist, während sein Kollektor am Bezugspotential $U_{B-}$
liegt.

Die in Figur 3 dargestellte Ausgestaltung einer Verstärkerschaltung gemäß der Erfindung unterscheidet sich gegenüber der Schaltung gemäß Figur 2 nur dadurch, indem
die beiden Stromquellen $K_1^*$ und $K_2^*$ detailliert in Form von
Stromspiegeln dargestellt und derart aufeinander abgestimmt sind, daß beide Stromquellen denselben Wert $J_o$ des
Konstantstroms liefern.

Hierzu ist der positive Anschluß $U_{B+}$ Der Versorgungsspannung - gegebenenfalls über einen Widerstand oder ein sonstiges Einstellglied G - an den Kollektor und an die Basis
eines npn-Transistors T2 gelegt, dessen Emitter an der Bezugspotentialklemme $U_{B-}$ liegt. Außerdem sind der Emitter
und die Basis dieses npn-Transistors T2 zur Steuerung zweier weiterer npn-Transistoren T1 und T3 vorgesehen, die zusammen mit dem Transistor T2 die aus npn-Transistoren zusammen gesetzte Konstantstromquelle $K_2^*$ bilden, die zur Beaufschlagung des npn-Transistors $Q_4^*$ dient. Außerdem ist
der Kollektor des npn-Transistors T1 über den Eingangstransistor t1 des pnp-Stromspiegels $K_1^*$ an das positive Versor-

gungspotential $U_{B+}$ gelegt und liefert deshalb den Eingangsstrom für den pnp-Stromspiegel $K_1^*$. Der npn-Transistor T2 des Stromspiegels $K_2^*$ und der pnp-Transistor t1 des Stromspiegels $K_1^*$ ist durch Kurzschluß seines Basis-Kollektor-pn-Übergangs als Diode geschaltet, während die Kollektoren des npn-Transistors T3 und des pnp-Transistors t2 den Ausgang des betreffenden Stromspiegels $K_2^*$ bzw. $K_1^*$ bilden.

Die Schaltung läßt sich, wie bereits bemerkt, auch in MOS-Technik realisieren, wobei die pnp-Transistoren durch p-Kanal-MOS-FET's und die npn-Transistoren durch n-Kanal-MOS-FET's zu ersetzen sind. Dies gilt auch für die Stromspiegelschaltungen. Der Drainanschluß der einzelnen, zweckmäßig als selbstsperrende MOS-FET's ausgebildeten Feldeffekttransistoren ist dann die Stromausgangselektrode, der Sourceanschluß die Stromeingangselektrode und das Gate die Steuerelektrode im Sinne der Definition der Erfindung.

Bei der erfindungsgemäßen Schaltung für einen monolithisch integrierbaren Verstärker durchfließt der von den beiden Stromquellen $K_1^*$ und $K_2^*$ gelieferte Strom $J_o$ sowohl den pnp-Transistor $Q_3^*$ als auch den npn-Transistor $Q_4^*$, so daß der Ruhestrom der Verstärkerschaltung insgesamt nur gleich $2 \cdot J_o$ ist, wie man sofort aus der Schaltung ersieht. Voraussetzung dafür ist, daß bezüglich der geometrischen Abmessungen der Transistor Q2 mit dem Transistor $Q_3^*$ und der Transistor Q1 mit dem Transistor $Q_4^*$ gleich ist. Um den Sättigungszustand bei den Transistoren $Q_3^*$ und $Q_4^*$ zu vermeiden, sind die Kollektoren dieser Transistoren an den Emitter je eines zu dem betreffenden Transistor $Q_3^*$ bzw. $Q_4^*$ komplementären Transistors Q1 bzw. Q2 geschaltet. Dadurch werden die Transistoren $Q_3^*$ und $Q_4^*$ mit einer Emitterspannung $U_{CB}$ von nahezu gleich 0 V betrieben. Gleichzeitig können geringe Differenzströme in den Kollektoren der Transistoren $Q_3^*$ und $Q_4^*$ über die Emitter der Transistoren Q1 und Q2 ausgeglichen werden. Die genannten Wirkungen sind auch bei einer Realisierung in MOS-Technik gegeben.

Im Interesse der Optimierung der angestrebten Wirkung empfiehlt es sich, wenn die Gleichspannungskomponente des vom Verstärker zu übertragenden Signals der Hälfte der Versorgungsgleichspannung entspricht, weil dann die maximal mögliche Aussteuerung erreicht werden kann.

3 Figuren
5 Patentansprüche

0073353

## Patentansprüche

1.) Halbleiter-Verstärkerschaltung mit zwei zueinander komplementären Transistoren, deren Stromeingangselektroden mit dem Signalausgang der Verstärkerschaltung verbunden und deren Stromausgangselektroden an je eine durch eine Versorgungs-Gleichspannungsquelle beaufschlagte Versorgungsklemme gelegt sind, während ihre Steuerelektroden mit der Stromeingangselektrode jeweils eines weiteren, zu dem betreffenden Transistor komplementären Transistors verbunden sind, dadurch gekennzeichnet, daß die Stromeingangselektroden der beiden weiteren komplementären Transistoren ($Q_3^*$, $Q_4^*$) über je eine Konstantstromquelle ($K_1^*$, $K_2^*$) mit der zugehörigen Versorgungsklemme ($U_{B+}$, $U_{B-}$) verbunden sind, während ihre Steuerelektroden gemeinsam an die durch ein Eingangssignal zu beaufschlagende Eingangsklemme (E) gelegt und ihre Stromausgangselektroden miteinander sowie mit dem Ausgang (A) des Verstärkers verbunden sind.

2.) Verstärkerschaltung nach Anspruch 1, dadurch gekennzeichnet, daß die beiden, z.B. als Stromspiegel ausgestalteten Konstantstromquellen ($K_1^*$, $K_2^*$) derart aufeinander abgestimmt sind, daß sie jeweils denselben Strom ($J_0$) an den Stromeingang des jeweils zugeordneten Transistors ($Q_1^*$, $Q_2^*$) weitergeben.

3.) Verstärkerschaltung nach Anspruch 1 oder 2, dadurch gekennzeichnet, daß die zur Steuerung des Verstärkers vorgesehene Signalquelle derart ausgestaltet ist, daß das an den Signaleingang (E) des Verstärkers gelangende Signal zusätzlich zu der das Signal darstellenden Wechselspannungskomponente eine Gleichspannungskomponente -insbesondere mit der Stärke der halben Versorgungsspannung ($U_B$) - aufweist.

4.) Verstärkerschaltung nach einem der Ansprüche 1 bis 3, dadurch gekennzeichnet, daß die im Verstärker verwendeten Transistoren durch Bipolartransistoren gegeben sind.

5.) Verstärkerschaltung nach Anspruch 2, dadurch gekennzeichnet, daß die durch je einen Stromspiegel gegebenen Konstantstromquellen ($K_1^*$, $K_2^*$) derart ausgebildet sind, daß der eine Stromspiegel aus Transistoren vom einen Leitfähigkeitstyp (T1, T2, T3) besteht und zur Beaufschlagung weiteren Komplementärtransistors ($Q_4^*$) vomselben Leitfähigkeitstyp dient, während der andere Stromspiegel aus Transistoren vom anderen Leitfähigkeitstyp (t1, t2) besteht und zur Beaufschlagung des denselben Leitfähigkeitstyp wie die zuletzt genannten Transistoren aufweisenden weiteren Transistors ($Q_3^*$) dient, und daß außerdem der Eingang (T2) des einen Stromspiegels (T1, T2, T3) neben der Steuerung des zugeordneten weiteren Transistors ($Q_4^*$) mittels eines ersten Ausgangstransistors (T3) zur Steuerung des anderen - komplementären - Stromspiegels (t1, t2) mittels eines zweiten Ausgangstransistors (T1) dient.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| | --- | | H 03 F 3/30 |
| Y | DE-A-2 646 386 (LICENTIA PATENT-VERWALTUNG) * Figuren 2,4; Seite 5, Zeile 18 - Seite 6, Zeile 28 * | 1,2,4, 5 | |
| | --- | | |
| Y | ELECTRONICS DESIGN, Band 29, Nr. 8, 16. April 1981, Seiten 153-157, Wasecamn, Denville, N.J., USA T.J. SCHWARTZ: "Dual matched op amps serve instrumentation needs" * Seite 155 * | 1,2,4, 5 | |
| | --- | | |
| A | DE-A-3 035 471 (PIONEER ELECTRONIC CORP.) * Figuren 2,4; Seite 22, Zeilen 4-28 * | 2,5 | |
| | ----- | | RECHERCHIERTE SACHGEBIETE (Int. Cl. 3) H 03 F |

Der vorliegende Recherchenbericht wurde für alle Patentansprüche erstellt.

| Recherchenort DEN HAAG | Abschlußdatum der Recherche 16-12-1982 | Prüfer TYBERGHIEN G.M.P. |
|---|---|---|